# EUROPEAN PATENT SPECIFICATION

(11) **EP 4 272 034 B1**
(45) Date of publication and mention of the grant of the patent: **18.02.2026**
(21) Application number: 21841020.7
(22) Date of filing: 28.12.2021
(51) Int. Cl.: G03F 7/00

(54) **METALLIC NANOHOLE ARRAYS ON NANOWELLS WITH CONTROLLED DEPTH AND METHODS OF MAKING THE SAME**
METALLISCHE NANOLOCHARRAYS AUF NANOVERTIEFUNGEN MIT KONTROLLIERTER TIEFE UND VERFAHREN ZUR HERSTELLUNG DAVON
RÉSEAUX DE NANOTROUS MÉTALLIQUES SUR DES NANOPUITS À PROFONDEUR CONTRÔLÉE ET LEURS PROCÉDÉS DE FABRICATION

(30) Priority: 31.12.2020 US 202063199478 P
(43) Date of publication of application: 08.11.2023
(73) Proprietor: 3M Innovative Properties Company, Saint Paul, Minnesota 55133-3427 (US)
(72) Inventor: SMITH, Matthew R.D., Saint Paul, Minnesota 55133-3427 (US); TARNOWSKI, David J., Saint Paul, Minnesota 55133-3427 (US); KANG, Myungchan, Saint Paul, Minnesota 55133-3427 (US); NELSON, Caleb T., Saint Paul, Minnesota 55133-3427 (US); VAN LENGERICH, Henrik B., Saint Paul, Minnesota 55133-3427 (US); LYONS, Christopher S., Saint Paul, Minnesota 55133-3427 (US); SOLOMON, Jeffrey L., Saint Paul, Minnesota 55133-3427 (US); HAO, Bing, Saint Paul, Minnesota 55133-3427 (US); STENSVAD, Karl K., Saint Paul, Minnesota 55133-3427 (US)
(74) Representative: Mathys & Squire
(86) International application number: PCT/IB2021/062392
(87) International publication number: WO 2022/144774

(56) References cited:
- EP-B1- 3 035 369
- CN-A- 109 795 979
- US-A1- 2002 192 976
- US-A1- 2003 091 937
- US-A1- 2006 160 366
- US-A1- 2013 295 325
- US-A1- 2014 322 081
- US-A1- 2018 157 169
- US-B1- 6 451 705

## Description

### BACKGROUND

Nanostructures such as nanohole or nanowell arrays on substrates can exhibits extraordinary properties. For example, it was discovered that there is extraordinary optical transmission through nanohole arrays ("Extraordinary optical transmission through sub-wavelength hole arrays," Nature 391, 667-669 (1998)).

US 2018/157169 A1 and US 2003/091937 A1 disclose nanohole arrays formed in resist provided with metal layers deposited thereon.

### SUMMARY

The present invention is defined in the appended independent claims 1 and 10.

Briefly, in one aspect, the present disclosure describes a method including providing an array of nanowells on a first major surface of a polymeric layer, the array of nanowells including openings being interspersed between land areas thereof, the nanowells each having a base and a sidewall connecting the base and the land areas thereof, and depositing a metallic layer at least on the land areas to form a mesh pattern of metal having an array of nanoholes aligned with the openings of the respective nanowells. The nanowells each have an aspect ratio of depth to opening size greater than about 0.5 to prevent a substantial deposition of the metal into the nanowells on the bases thereof. The metallic layer has a first thickness T1 on the land areas, and a second thickness T2 on the base of the nanowells, the ratio of T2 over T1 is no greater than 50%, no greater than 20%, no greater than 10%, optionally, no greater than 5%. In some cases, the array of nanowells is provided by providing a pattern layer on the first major surface of the polymeric layer, the pattern layer having a first surface adjacent to the etchable polymeric layer, and a second surface opposite to the first surface, the second surface including nanostructures characterized by feature dimensions of width, length, and height; and etching from the second surface of the pattern layer into the first major surface of the etchable polymeric layer to form the array of nanowells.

In another aspect, the present disclosure describes an article including an etchable polymeric layer having a first major surface and a second major surface opposite the first major surface, and an array of nanowells formed into the first major surface of the etchable polymeric layer. The array of nanowells includes openings being interspersed between land areas thereof, the nanowells each having a base and a sidewall connecting the base and the land areas thereof. The nanowells each have a ratio of depth to opening size greater than about 0.5. The article further includes a metallic layer disposed at least on the land areas. The metallic layer forms a mesh pattern having an array of nanoholes aligned with the openings of the respective nanowells.

Various unexpected results and advantages are obtained in exemplary embodiments of the disclosure. One such advantage of exemplary embodiments of the present disclosure is that the aspect ratio of the nanowells can be controlled to be sufficiently high to prevent a substantial deposition of metal into the nanowells.

Various aspects and advantages of exemplary embodiments of the disclosure have been summarized. The above Summary is not intended to describe each illustrated embodiment or every implementation of the present certain exemplary embodiments of the present disclosure. The Drawings and the Detailed Description that follow more particularly exemplify certain preferred embodiments using the principles disclosed herein.

### BRIEF DESCRIPTION OF THE DRAWINGS

The disclosure may be more completely understood in consideration of the following detailed description of various embodiments of the disclosure in connection with the accompanying figures, in which:
FIG. 1 is a schematic diagram of a process to make an article including metallic nanohole arrays, according to one embodiment.
FIG. 2 is a schematic diagram of a process to make an article including metallic nanohole arrays, according to another embodiment.
FIG. 3 is a schematic top view of the article of FIG. 1 or FIG. 2, according to some embodiments.
FIG. 4 is a schematic cross-sectional view of a metallic nanohole formed on a nanowell, according to one embodiment.
FIG. 5A is a microscopic image of Example 1.
FIG. 5B is a microscopic image of Example 2.
FIG. 5C is a microscopic image of Example 3.
FIG. 5D is a microscopic image of Example 4.

In the drawings, like reference numerals indicate like elements. While the above-identified drawing, which may not be drawn to scale, sets forth various embodiments of the present disclosure, other embodiments are also contemplated, as noted in the Detailed Description. In all cases, this disclosure describes the presently disclosed disclosure by way of representation of exemplary embodiments and not by express limitations. It should be understood that numerous other modifications and embodiments can be devised by those skilled in the art, which fall within the scope of this disclosure.

### DETAILED DESCRIPTION

The present disclosure provides methods of forming metallic nanohole arrays on nanowells with a controlled depth. A mesh pattern of metal layer having an array of nanoholes is provided on an array of nanowells, aligned with the openings of the respective nanowells. The aspect ratio of the nanowells are controlled to be sufficiently high to prevent a substantial deposition of metal into the nanowells. By controlling the aspect ratio of the nanohole opening to the depth of the nanowells, the metal deposition thicknesses can be tuned on both the tops of the array features and on the bottoms of the nanowells. Embodiments of this disclosure allow for the metal deposition thickness on the top of the array to be much greater than that in the nanowells.

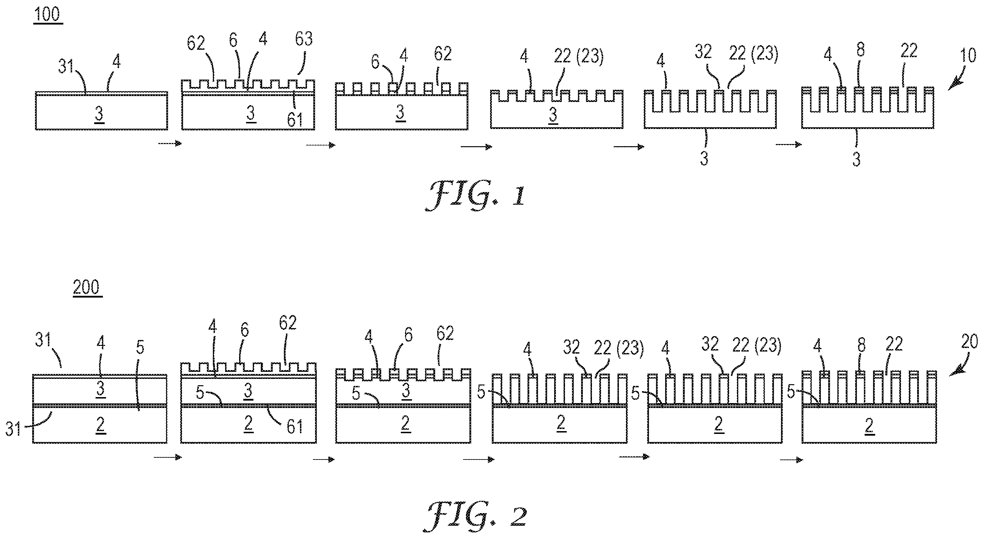

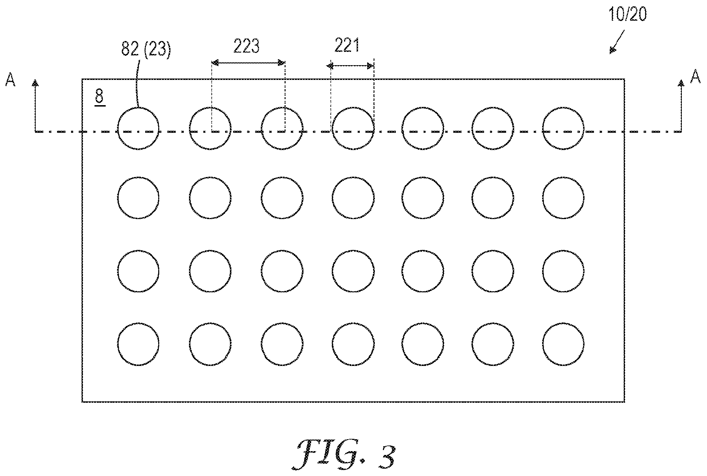

FIG. 1 is a schematic diagram of a process 100 to make an article 10 including metallic nanohole arrays on nanowell arrays, according to one embodiment. FIG. 2 is a schematic diagram of a process 200 to make an article 20 including metallic nanohole arrays on nanowell arrays, according to another embodiment. FIG. 3 is a schematic top view of the article 10 of FIG. 1 or the article 20 of FIG. 2, according to some embodiments. FIGS. 1 and 2 are the cross-sectional view of FIG. 3 along a line A-A.

A pattern layer 6 is provided on a first major surface 31 of an etchable polymeric layer 3. A hard mask layer 4 is disposed on the first major surface 31 of the etchable polymeric layer 3, being sandwiched between the pattern layer 6 and the etchable polymeric layer 3. The pattern layer 6 has a first surface 61 adjacent to the etchable polymeric layer 3, and a second surface 63 opposite the first surface 61. The second surface 63 includes a pattern 62 characterized by feature dimensions of width, length, and height. The pattern layer 6 can be produced, for example, by replication, molding, or photolithography. The pattern layer 6 can be made of polymeric materials, for example radiation curable, dissolvable polymer, thermoplastic or thermosetting polymer. In some embodiments, a second pattern transfer layer can be patterned using reactive ion etching (RIE) with a variety of different chemistries and specified conditions.

In some embodiments, the pattern layer 6 can include a nano-replicated resin layer formed by a nanoreplication method. As used herein, "nanoreplication" refers to a process of molding a nanostructured surface from another nanostructured surface using, for example, curable or thermoplastic materials. Nanoreplication is further described, for instance, in "Micro/Nano Replication", Shinill Kang, John Wiley & Sons, Inc., 2012, Chapters 1 and 5-6. The pattern layer can be formed by applying a curable composition onto a nanostructured surface and replicating a pattern therefrom. The curable composition can include any suitable materials that can be solidified by radiation or heat. For example, the curable composition may include a UV-curable acrylate. Exemplary curable compositions for a nanoreplication method are described in PCT Patent Application Publication WO2021053534A1.

It is to be understood that the pattern layer 6 may be prepared by any suitable processes other than a nanoreplication method. The pattern layer 6 can be built up from a variety of materials depending on the technique used to generate the pattern layer.

A reactive ion etching (RIE) can be carried out to etch, from the second surface 63 of the pattern layer 6, into the first major surface 31 of the etchable polymeric layer 3 to form an array of nanowells 22 including openings 23 being interspersed between land areas 32 thereof. The etching process is used to transfer a pattern from the pattern layer 6 to the etchable polymeric layer 3 beneath. It is to be understood that any suitable selective etching process other than RIE can be used. Exemplary selective etching can be carried out using carried out using reactive ion etching, high density RF inductive plasma etching, high density linear ion plasma etching, microwave plasma etching, linear microwave plasma etching, helicon wave plasma etching, ion-beam milling, pulsed ion beam etching, pulsed reactive ion etching, or a combination thereof.

Transferring the pattern of a masking layer (e.g., the pattern layer 6) into the underlying layers (e.g., the etchable polymeric layer 3) can be achieved by plasma etching. Where high aspect ratio structures are needed, ion-assisted plasma processing is conveniently used. Methods for achieving anisotropic etching include reactive ion etching (RIE), high density ion source processing, or a combination of high-density ion source processing along with RIE. High density plasmas can be generated by inductive RF, or microwave coupling, or by helicon ion sources. Linear high-density plasma sources are particularly advantageous for generating high aspect ratio features. Combining high density plasmas with RIE enables the decoupling of the ion generation (by high density plasma) from the ion energy (by RIE bias voltage).

The RIE method includes etching portions of the major surface not protected or less protected by the masking layer to form a nanostructure on a layer underneath the masking layer. In one embodiment, the provided method can be carried out using a continuous roll-to-roll process referred to as "cylindrical reactive ion etching" (cylindrical RIE). Cylindrical RIE utilizes a rotating cylindrical electrode to provide anisotropically etched nanostructures on the surface of a substrate or article. In general, cylindrical RIE can be described as follows. A rotatable cylindrical electrode ("drum electrode") powered by radio-frequency (RF) and a grounded counter-electrode are provided inside a vacuum vessel. The counter-electrode can include the vacuum vessel itself. An etchant gas is fed into the vacuum vessel, and a plasma is ignited and sustained between the drum electrode and the grounded counter-electrode.

A continuous substrate comprising a patterned masking layer can then be wrapped around the circumference of the drum and the substrate can be etched in the direction substantially normal to the plane of the substrate. The exposure time of the substrate can be controlled to obtain a predetermined etch depth of the resulting nanostructure. The process can be carried out at an operating pressure of approximately 1-10 mTorr. Cylindrical RIE is disclosed, for example, in U.S. Patent No. 8,460,568 (David et al.).

The chemistry of the plasma environment can be controlled to achieve selectivity of etching, when multiple materials are present. Oxygen, and mixtures of oxygen with fluorinated gases are used to etch carbon containing materials such as polymers, diamond-like carbon, diamond, and the like. The concentration of the fluorine in the plasma is critical to optimize the etching rate and selectivity. Typically, a small amount of fluorinated gas is used to dramatically increase the etching rate of hydrocarbon polymers by as much as 300%.

To etch silicon-containing materials (silicon dioxide, SiOx, diamond-like glass, silicon nitride, silicon carbide, silicon oxycarbide, polysiloxane, silicone, silicone acrylates, silsequioxane (SSQ) resins, etc), mixtures of fluorocarbons such as CF₄, C₂F₆, C₃F₈ and the like, are used in combination with oxygen. The etch selectivity between silicon containing materials and hydrocarbon polymers may be carefully tailored by obtaining the etching profiles of these materials as a function of the F/O atomic ratio in the plasma feed gas mixture. Oxygen rich conditions provide excellent selectivity of etching hydrocarbon polymers and diamond-like carbon (DLC) while using silicon materials as the masking layer. Additional materials for the masking layer are upper hard mask layer materials described in PCT Patent Application Publication WO2021053534A1. In contrast, fluorine rich conditions provide excellent selectivity of etching silicon-containing materials while using hydrocarbon polymer-based masking materials.

Fluorinated plasma chemistries may be used for etching other masking materials such as tungsten, whose fluorides are volatile. Chlorine containing gas mixtures may be used to etch materials whose chlorides are volatile, such as aluminum, and titanium. Oxide, nitrides and carbides of these etchable metals can also be etched by using chlorine-based chemistries. Silicon nitride, aluminum nitride, and titanium oxide are high index materials that may be etched with chlorine chemistries. Typical gases used for etching Include, for example, oxygen, nitrogen trifluoride (NF₃), CF₄, C₂F₆, C₃F₈, SF₆, Cl₂, CH₄, and the like.

In the embodiments depicted in FIGS. 1 and 2, a pattern of the pattern layer 6 is first transferred to the hard mask layer 4 by etching through the hard mask layer 4 to form a pattern onto the hard mask layer 4 directly beneath using the engineered nanostructures of the pattern layer 6 as a mask. An array of shallow nanowells are formed including openings being interspersed between land areas thereof. The land areas may include a residual pattern layer and the hard mask layer directly beneath. In some embodiments, the hard mask layer 6 includes a silicon-containing material and is reactive-ion etched using a fluorine-containing gas. The etchable polymeric layer 6 may include a hydrocarbon polymer and is resistant to the fluorine etch. It is to be understood that a reactive ion etching step (RIE) to etch the hard mask layer may be carried out using an etching chemistry that can be chosen based on the etching selectivity on the pattern layer on the top, the hard mask layer itself, and the etchable polymeric layer directly beneath.

A pattern formed on the hard mask layer 6 is then transferred to the etchable polymeric layer 3 directly beneath by etching into the etchable polymeric layer 3 using the pattern on the hard mask layer 4 as a mask. In some embodiments, the etchable polymeric layer 6 may include a hydrocarbon polymer and is reactive-ion etched using oxygen. The hard mask layer 4 may include a silicon-containing material and is resistant to the oxygen etch. It is to be understood that a reactive ion etching step (RIE) to etch the etchable polymeric layer may be carried out using an etching chemistry that can be chosen based on the etching selectivity on the pattern layer on the top, the hard mask layer underneath the pattern layer, the etchable polymeric layer itself, and an optional etch stop layer directly beneath.

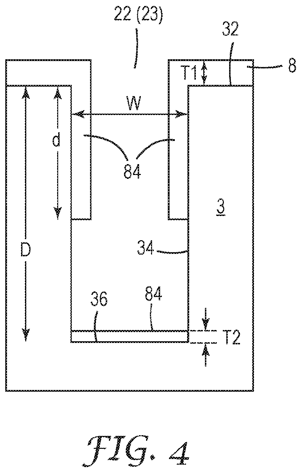

In the embodiment depicted in FIG. 1, the nanowells 22 can be etched to a desired depth, therefore controlling an aspect ratio (e.g., the ratio of depth D to opening size *W* as shown in FIG. 4) of the nanowells 22. For example, the time of oxygen etching can be varied to allow for controllable nanohole arrays to be formed before metallization. It is possible that there can be a run-to-run variation that has the possibility to impact the consistency of etching of the etchable polymeric layer to the same depth each time.

In the embodiment depicted in FIG. 2, an etch stop layer 5 is provided adjacent to a second major surface of the etchable polymeric layer 3 on the side opposite the first major surface 31 of the etchable polymeric layer 3. A support film 2 is provided to support the etchable polymeric layer 3. The etch stop layer 5 is sandwiched between the etchable polymeric layer 3 and the support film 2. The etch stop layer 5 may include a silicon-containing material and is resistant to the oxygen etch. Exemplary materials for an etch stop layer may include hard mask layer materials described in PCT Patent Publication No. WO 2020/095258 (Lengerich et al).

With the etch stop layer 5, the etching of the etchable polymeric layer 3 is automatically stopped at the etch stop layer 5 such that the nanowells 22 each have the base thereof reaching the etch stop layer 5. By using an etch stop layer directly beneath the etchable polymeric layer 3, the process allows for a desired thickness or aspect ratio to be achieved by controlling the layer thickness of the etchable polymeric layer 3. This may enable run-to-run consistency, by removing the need to precisely time the oxygen etching step.

The etchable polymeric layer 3 and the support film 2 can include the same or different materials. In some embodiments, the etchable polymeric layer and the support film may include a polymeric material that is in the form of a flat sheet and is sufficiently flexible and strong to be processed in a roll-to-roll fashion. Polymeric films used as an etchable polymeric layer or a support film in articles described herein are sometimes referred to as base films. By roll-to-roll, what is meant is a process where material is wound onto or unwound from a support, as well as further processed in some way. Examples of further processes include coating, slitting, blanking, and exposing to radiation, or the like. Polymeric films can be manufactured in a variety of thicknesses, ranging in general from, for example, 5 micrometers to 1000 micrometers. In some embodiments, polymeric film thicknesses range from 10 micrometers to 500 micrometers, or from 15 micrometers to 250 micrometers, or from 25 micrometers to 200 micrometers. Roll-to-roll polymeric films may have a width of at least 152.4 mm, 609.6 mm, 914.4 mm or 1219.2 mm (6, 24, 36 or 48 inches) Polymeric films can include, for example, poly(ethylene terephthalate) (PET), poly(butylenes terephthalate) (PBT), poly(ethylene naphthalate) (PEN), polycarbonate (PC), cyclic olefin copolymer (COP), polypropylene (PP), biaxially oriented polypropylene (BOPP), cellulose triacetate, a combination thereof, etc.

In some embodiments, the support film 2 may include a dielectric substrate including at least one of an optically transparent inorganic layer or an optically transparent polymeric layer. Exemplary inorganic layers may include at least one of glass, SiN, SiO₂, amorphous SiCₓO_{y}H_{z}, etc. Exemplary polymeric layers include polyethylene terephthalate, poly(methyl methacrylate), polyvinyl chloride, polyethylene, polypropylene, styrene methyl methacrylate, polycarbonate, polystryrene, and copolymers thereof.

In some embodiments, the etchable polymeric layer 3 may include at least one of a curable composition, monomer, or solution coatable polymer or resin. The etchable polymeric layer 3 is applied onto the etch stop layer 5, as shown in FIG. 2. The etchable polymeric layer 3 can be applied by any suitable processes such as, for example, casting, coating, deposition, dry film lamination and printing. Coating methods include spin coating, die coating, roll coating, spray, and evaporation. Printing methods include inkjet, gravure, flexographic and screen printing. After the polymeric layer is applied, it can be cured by actinic radiation or heat. The polymeric layer can also be a solution resin where the solvent is evaporated to form a dried film. Examples of polymeric layers include acylates, methacrylates, soluble polymers such as polyvinyl alcohol, polymer resins such as polyvinyl butyral, thermosetting polymers such as polyurethanes, thermoplastic polymers such as polypropylene.

An array of nanowells 22 is formed by etching into the first major surface 31 of the etchable polymeric layer 3. The array of nanowells 22 include openings 23 being interspersed between land areas 32 thereof. As shown in FIG. 4, the nanowells each have a base 36 and a sidewall 34 connecting the base 36 and the land areas 32 thereof. The nanowells each have the aspect ratio of depth *D* to opening size *W* in a range, for example, from about 0.5:1 to about 50:1, from about 1 to about 20: 1, optionally, from about 1.5:1 to about 10:1. As to be discussed further below, the nanowells each may have an aspect ratio high enough (e.g., greater than about 0.5, greater than about 1.0, greater than about 1.5, greater than about 2, or even greater than about 3) to substantially prevent a sputtering deposition of metal into the nanowells on the sidewalls and the bases thereof.

One traditional way to create nanowell arrays is through a UV-nanoreplication, or continuous cast and cure process. By using a nano-post mold, high-fidelity nanowells can be directly replicated onto a flexible substrate, enabling a lower cost fabrication of nanoholes from the methods mentioned above. The traditional nanoreplication processes may have limitations in the aspect ratio of structures that can be replicated. When the aspect ratio of the nanwells gets larger, it becomes increasingly difficult to peel the replication resin out without tearing, due to increased surface area contact of the resin with the mold.

Embodiments of the present disclosure provide nanowells having an aspect ratio sufficiently high (e.g., greater than about 0.5, greater than about 1.0, greater than about 1.5, greater than about 2, or even greater than about 3) to substantially prevent a sputtering deposition of metal into the nanowells. By controlling the aspect ratio of the nanohole opening to the depth of the nanowells, the metal deposition thicknesses can be tuned on both the tops of the array features and on the bottoms of the nanowells. Embodiments of this disclosure allow for the metal deposition thickness on the top of the array to be much greater than that in the nanowells. The array of nanowells has an average pitch in a range from 100 nm to 2500 nm, from 100 nm to 1000 nm, from 250 nm to 1000 nm, or optionally from 300 nm to 900 nm. The openings of the nanowells have an average opening size in a range from 10 to 90 percent, 15 to 85 percent, or optionally, from 20 to 80 percent of the pitch. The nanowells have an average depth in a range from 50 nm to 5000 nm, from 100 nm to 2000 nm, optionally, from 200 nm to 1000 nm.

A metallic layer 8 is deposited on the etched first major surface 31 of the etchable polymeric layer 3 to form a mesh pattern of metal having an array of nanoholes aligned with the openings 23 of the respective nanowells 22. The nanowells 22 each may have an aspect ratio of depth to opening size high enough (e.g., greater than about 0.5, greater than about 1.0, greater than about 1.5, greater than about 2, or even greater than about 3) to prevent a substantial deposition of metal into the nanowells on the sidewalls and the bases thereof.

The metallic layer 8 is deposited by sputter deposition. PVD processes are preferred due to the ease in which the upper surfaces of nanowell structures (e.g., the land areas 32 in FIG. 4) are coated with little deposition on the lower surfaces of nanowell structures (e.g., the base 36 and the sidewall 34 of a nanowell in FIG. 4). In addition, CVD and the related processes plasma-assisted CVD and atomic layer deposition (ALD) may be more difficult to control the deposition preferentially to the upper surfaces of nanowell structures.

A suitable sputter deposition process can use conventional cathode or magnetron sputter sources with targets of the metal to be deposited. DC, pulsed-DC, AC, or RF power supplies can be used to power the plasma that provides the energetic ions and electric field necessary to sputter deposit the atoms from the target onto the substrate. The sputtering is done in a vacuum process with an inert gas such as Ar at a pressure in the range of 0.133 Pa to 2 Pa. In one embodiment, nanowell structures with depth/opening size aspect ratios (AR) greater than, for example, about 1:1, about 2:1, or about 3:1, can be preferentially coated on the upper surfaces (e.g., the land areas 32 in FIG. 4) with sputter deposition at a normal angle (i.e., a sputter target being positioned substantially parallel and directly over the substrate). The sputter target and the substrate are positioned such that the sputter deposition is within ±5 degrees from the normal direction.

The metallic layer may include at least one of gold, silver, aluminum, copper, platinum, ruthenium, nickel, palladium, rhodium, iridium, chromium, iron, lead, tin, zinc, a combination or alloy thereof. The metallic layer may have an average thickness in a range from 25nm to 500nm, from 30nm to 200nm, optionally, from 30nm to 150nm.

The mesh pattern of the metallic layer 8 can be a repeating pattern including at least one of a square lattice, a rectangular lattice, a hexagonal lattice, a rhombic lattice, or a parallelogrammic lattice. One exemplary mesh patter of the metallic layer 8 is illustrated in FIG. 3. The metallic layer 8 forms the mesh pattern having an array of nanoholes 82 aligned with the openings 22 of the respective nanowells of the etchable polymeric layer 3 of FIG. 1 or 2. The openings 82 or 22 typically have a pitch 223 in a range from 100 nm to 2500 nm, from 100 nm to 1000 nm, from 250 nm to 1000 nm, or optionally from 300 nm to 900 nm. As used herein, the term "pitch" refers to the distance from the center of one opening to the center of the next nearest opening. The opening 82 or 22 may have any suitable regular or irregular shape including, for example, spherical, oval, trigonal, rectangular, polygonal, etc. The openings 82 or 22 typically have an opening size 221 in a range from 5 to 95 percent of the pitch 223. The opening size 221 is a shorter dimension of a minimum bounding rectangle of the irregular shape. The minimum bounding rectangle is defined as a rectangle whose sides are respectively parallel to two orthogonal axes (e.g., x and y axes in Cartesian coordinates) and minimally enclose the shape. In some embodiments, the opening size 221 is in a range from 10 to 90, 15 to 85, or even 20 to 80 percent of the pitch. The opening size 221 of a circular opening is the diameter of the opening. The opening size 221 for an oval opening is the length of its minor axis. The opening size 221 for a polygonal opening is based upon the length of the shortest line that can be drawn from one vertex, through the center of the opening, to the opposite side of the opening.

FIG. 4 is a schematic cross-sectional view of an exemplary metallic nanohole formed on a nanowell, according to one embodiment. The metallic layer 8 has a first thickness T1 on the land areas 32, and a second thickness T2 on the base 36 of the nanowells. The thickness ratio of T2 over T1 is no greater than 50%, no greater than 20%, no greater than 10%, optionally, no greater than 5%. The thickness ratio of T2 over T1 can be controlled by controlling the aspect ratio of the nanowells and/or the metal deposition process as discussed above. By controlling the aspect ratio of the nanowells, the metal deposition thicknesses can be tuned on both the land areas and on the bottoms of the nanowells. In some embodiments, the process described herein can be controlled such that the second thickness T2 on the base 36 of the nanowells is no greater than 30 nm, no greater than 20 nm, no greater than 10 nm, or no greater than 5 nm.

The metallic layer 8 may extend from the land areas 32 into the nanowells along the sidewalls 34 to form a sidewall portion 84 with a depth *d* and form a wrapping around structure. In other words, the metallic layer 8 may wrap around the corners of the nanowells that connect to the land areas 32. In some embodiments, the depth *d* may be no less than 1%, no less than 2%, no less than 3%, no less than 5%, or no less than 10% of a nanowell depth D. In some embodiments, the depth *d* may be no greater than 95%, no greater than 50%, no greater than 30%, or no greater than 20% of a nanowell depth D. The nanowells 22 have an average depth D in a range, for example, from 50 nm to 5000 nm, from 100 nm to 2000 nm, optionally, from 200 nm to 1000 nm.

In some embodiments, the land areas 32 may have a residual hard mask layer 4 disposed thereon which is sandwiched between the metallic layer 8 and the etchable polymeric layer 3. See also FIG. 1 or 2. Depending on the etching chemistry applied, the residual hard mask layer 4 may have a thickness, for example, in a range from 0 to 100% of the original hard mask thickness. In some embodiments, there may be no substantially residual material of the hard mask layer 4 between the metallic layer 8 and the etchable polymeric layer 3 on the land areas 32. When an etch stop layer is used such as the etch stop layer 5 shown in the process of FIG. 2, the nanowells each may have the respective bases 36 thereof reaching the etch stop layer 5. In some embodiments, the etching of the etchable polymeric layer can be automatically stopped at the etch stop layer 5. In some embodiments, the etching of the etchable polymeric layer can be controlled to stop before reaching the etch stop layer 5.

The operation of the present disclosure will be further described with regard to the following detailed examples. These examples are offered to further illustrate the various specific and preferred embodiments and techniques. It should be understood, however, that many variations and modifications may be made while remaining within the scope of the present disclosure.

### EXAMPLES

These Examples are merely for illustrative purposes and are not meant to be overly limiting on the scope of the appended claims. Notwithstanding that the numerical ranges and parameters setting forth the broad scope of the present disclosure are approximations, the numerical values set forth in the specific examples are reported as precisely as possible. Any numerical value, however, inherently contains certain errors necessarily resulting from the standard deviation found in their respective testing measurements. At the very least, and not as an attempt to limit the application of the doctrine of equivalents to the scope of the claims, each numerical parameter should at least be construed in light of the number of reported significant digits and by applying ordinary rounding techniques.

### Summary of Materials

Unless otherwise noted, all parts, percentages, ratios, etc. in the Examples and the rest of the specification are by weight. Table 1 provides abbreviations and a source for all materials used in the Examples below:

**Table 1: Materials**

| **Designation** | **Description** | **Source** |
|---|---|---|
| PHOTOMER 6210 | Urethane acrylate oligomer available under the trade designation PHOTOMER 6210 | IGM Resins, Charlotte, NC, United States |
| SR238 | 1,6-Hexandiol diacrylate available under the designation SR238 | Sartomer Americas, Exton, PA, United States |
| SR351 | Trimethylopropane triacrylate available under the designation SR351 | Sartomer Americas, Exton, PA. United States |
| SR833 | Tricylclodecane dimethanol diacrylate available under the designation SR833 | Sartomer Americas, Exton, PA, United States |
| TPO | Diphenyl(2,4,6- trimethylbenzoyl)phosphine oxide available under the trade designation IRGACURE TPO | BASF, Florham Park, NJ, United States |
| TPO-L | 2,4,6-trimethylbenzoylphenylphosphinic acid ethyl ester available under the trade designation IRGACURE TPO-L | BASF, Florham Park, NJ, United States |
| 90% Si/10% Al | Sputter Target 90% Silicon/ 10% Aluminum | Protech Materials, Hayward, CA, United States |
| 85%Ag/15%Au | Sputter Target 85% Silver/ 15% Gold | DHF Technical Products, Rio Ranch, NM, United States |
| O₂ | Oxygen (UHP compressed gas) | Oxygen Service Company, Saint Paul, MN, United States |
| Ar | Argon (UHP compressed gas) | Oxygen Service Company, Saint Paul, MN, United States |
| K90 | 2-(3-trimethoxysilylpropylcarbamoyloxy)ethyl prop-2-enoate assembled as described in Example 7 of U.S. Patent No. 9,790,396 (Klun et al.) | 3M Company, St Paul, MN, United States |
| 184 | Methanone, (1-hydroxycyclohexyl)phenyl-ketone) available under the trade designation IRGACURE 184 | BASF, Florham Park, NJ, United States |
| HFPO | Hexafluoropropyleneoxide dihydro diol | 3M Company, |
| | diacrylate assembled as described in the Examples of U.S. Patent No. 9,718,961 (Corveleyn et al.) | Saint Paul, MN, United States |
| HFPO-UA | Hexafluoropropyleneoxide multiacrylate assembled as described in the Examples of U.S. Patent No. 7,173,778 (Jing et al.) | 3M Company, Saint Paul, MN, United States |
| PGME | Propylene Glycol Methyl Ether | Brenntag Great Lakes, Wauwatosa, WI, United States |
| MEK | Methyl ethyl ketone | Brenntag Great Lakes, Wauwatosa, WI, United States |
| HMDSO | Hexamethyldisiloxane | Gelest Inc., Morrisville, PA, United States |
| PF-5060 | Fully-fluorinated liquid (C₆F₁₄) available under the designation PF-5060 | 3M Company, Saint Paul, MN, United States |
| ST504 | Polyester film available under the trade designation MELINEX ST504 | **Du** Pont Teijin Films, Chester, VA, United States |
| ST505 | Polyester film available under the trade designation MELINEX ST505 | **Du** Pont Teijin Films, Chester, VA, United States |
| Polycarbonate Film | 125-micron thick polycarbonate film with a gloss surface finish on both sides | Tekra, Inc., New Berlin, WI, United States |

### Preparatory Example 1 (PE1)

Resin A was prepared by combining and mixing PHOTOMER 6210, SR238, SR351 and TPO in weight ratios of 60/20/20/0.5.

### Preparatory Example 2 (PE2)

Resin B was prepared by combining 75 wt% PHOTOMER 6210 with 25 wt% SR238 and 0.5% TPO to create a first acrylate mixture. 93 wt% of the first acrylate mixture was manually mixed with 7 wt% HFPO-UA resulting in a second acrylate mixture. The acrylate solution was then created by manually combining 14 wt% of the second acrylate mixture with 43 wt% PGME and 43 wt% MEK.

### Preparatory Example 3 (PE3)

An adhesive promoter solution was prepared by adding 0.3 wt% of K90 with 99.7 wt% MEK and 0.003 wt% TPO-L.

### Processing Methods

### Method of Making a Tooling Film via UV Replication

A tooling film was created via UV replication against a nickel master. The nickel master was a nanostructured tool with a 65 mm x 65 mm square packed hole array of 310 nm deep holes having a diameter of 200 nm, a pitch of 400 nm, and a draft angle of 6.3 degrees. Resin A prepared and coated onto a 125 µm thick polycarbonate film to sufficiently wet the nickel surface and form a rolling bead of resin as the coated polycarbonate film was pressed against the nanostructured nickel surface.

The film was exposed to radiation from two Fusion UV lamp systems ("F600" from Fusion UV Systems) fitted with D bulbs both operating at 142 W/cm while in contact with the nanostructured nickel surface. After peeling the film from the nanostructured nickel surface, the nanostructured side of the film was again exposed to radiation from a Fusion UV lamp system. Following the UV radiation in contact with the surface and the subsequent fusion exposure, Resin A was solidified in a square packed array of posts, the opposite generation of the nickel tooling.

### Method for Release Treatment

A silicon containing release film layer assembled according to methods described in U.S. Patent Nos. 6,696,157 (David et al.) and 8,664,323 (Iyer et al.) and U.S. Patent Publication No. 2013/0229378 (Iyer et al.) was applied to the nanostructure tooling film in a parallel plate capacitively coupled plasma reactor. The chamber has a central cylindrical powered electrode with a surface area of 1.7 m² (18.3 ft²).

After placing the nanostructured tooling film on the powered electrode, the reactor chamber was pumped down to a base pressure of less than 1.3 Pa (2 mTorr). O₂ gas was flowed into the chamber at a rate of 1000 SCCM. Treatment was carried out using a plasma enhanced CVD method by coupling RF power into the reactor at a frequency of 13.56 MHz and an applied power of 2000 watts. Treatment time was controlled by moving the nanostructured tooling film through the reaction zone at rate of 9.1 meter/min (30 ft/min) resulting in an approximate exposure time of 10 seconds. After completing the deposition, RF power was turned off and gasses were evacuated from the reactor.

Following the first treatment, a second plasma treatment was carried out in the same reactor without returning the chamber to atmospheric pressure. HMDSO gas was flowed into the chamber at approximately 1750 SCCM to achieve a pressure of 9 mTorr. 13.56 MHz RF power was subsequently coupled into the reactor with an applied power of 1000 W. The film was then carried through the reaction zone at a rate of 9.1 m/min (30 ft/min) resulting in an approximate exposure time of 10 seconds. At the end of this treatment time, the RF power and the gas supply were stopped, and the chamber was returned to atmospheric pressure.

### Method of Preparing a Single Etch Block Layer

A silicon containing etch resist was deposited using the reactor in Method for a Release Treatment, demonstrating Layer 4 in FIG. 1. After placing the etchable polymeric layer of ST504 PET film on the powered electrode, the reactor chamber was pumped down to a base pressure of less than 1.3 Pa (2 mTorr). Oxygen and HMDSO gases were flowed into the chamber at a rate of 2000 SCCM, and 100 SCCM respectively. Treatment was carried out using a plasma enhanced CVD method by coupling RF power into the reactor at a frequency of 13.56 MHz and an applied power of 7500 watts. Treatment time was controlled by moving the film through the reaction zone at rate of 4.6 m/min (15 ft/min) resulting in an approximate exposure time of 20 seconds. After completing the deposition, RF power was turned off and gasses were evacuated from the reactor. Following the first treatment, a second plasma treatment was carried out in the same reactor without returning the chamber to atmospheric pressure. Oxygen gas was flowed into the chamber at approximately 1000 SCCM. 13.56 MHz RF power was subsequently coupled into the reactor with an applied power of 6000 W. The film was then carried through the reaction zone at a rate of 9.1 m/min (30ft/min), resulting in an approximate exposure time of 10 seconds. At the end of this treatment time, the RF power and the gas supply were stopped, and the chamber was returned to atmospheric pressure.

### Method of Preparing a Three-Laver Stack with Two Etch Block Laver

A three-layer stack with two etch block layers was utilized to precisely control the depth of the nanohole array in Fig. 2. The three-layer-stack was deposited onto 127 micron thick, 292 mm wide Melinex ST505 PET film (DuPont Teijin Films, Chester, VA) in a roll-to-roll vapor coater as described in US Patent No. 9,254,506. In a first pass through the vapor coater, the film was plasma treated, vapor coated with 40 nm of SiAlOx etch stop, vapor coated with 800 nm of acrylate (etchable polymeric layer), and cured. In a second pass through the vapor coater, the film was coated with a top SiAlOx etch mask 25 nm thick.

The SiAlOx layers were deposited by dual ac reactive sputtering from two cylindrical targets of 90%Si/10%Al, at a pressure of 0.336 Pa (Argon flow of 29.4 sccm and O₂ flow of 228 sccm), a mid-frequency ac sputtering power of 16 kW. The line speed of the first pass was 3.05 m/min and the line speed of the second pass was 4.88 m/min. The acrylate layer was deposited immediately downstream of the first SiAlOx layer. Tricyclodecyldimethanol diacrylate (SR833, Sartomer/Arkema Exton, PA) was mixed with 4% (wt) Irgacure 184 and 6.7% (wt) K90 and degassed to a pressure of 100 mtorr. Then this mixture was pumped through a syringe pump at a flowrate of 0.55 mL/min through an ultrasonic atomizer (Sono-tek) into a heated evaporator at 250°C. The atomized droplets flash evaporated, and the vapor flowed through an 203.2 mm wide coating die to condense onto the chilled PET film at a line speed of 3.05 m/min. This liquid thin film was cured with UVC radiation from an amalgam low pressure mercury arc lamp (Heraeus mercury-amalgam low pressure, Model No. Strahlet MNIQ 15-/54 XL 3M, 254nm peak output), creating a polymerized acrylate layer 800 nm thick.

Without venting the chamber, the evaporator was cooled and then the film run through the coater for the second pass top SiAlOx deposition. After deposition, the roll of film was removed from the coater and heat aged in an oven at 50°C and ambient humidity for 24 hours.

### Method of Liquid Coating the Adhesion Promoter

The adhesion promoter solution prepared in PE3 was coated in 15.24 cm wide stripes onto the etch block film using a slot die to enable adhesion of a urethane acrylate coating. The solution was pumped using a Harvard syringe pump at 3 sccm onto the film, which was moving at a rate of 0.10 meters per second. The film moved through a 65°C oven for 1.5 minutes after which it was cured using a Fusion H bulb and subsequently wound up.

### Method of Low-Land Transfer of Nanostructure onto Etch Block Film

The release treated nanostructured post film was next coated with Resin B (prepared in PE2) at 10.2 cm wide via a slot die coater, fed through a Harvard syringe pump at a rate of 1.8 sccm with the process line running at 3.04 meters per second. The coating was dried at ambient conditions and was subsequently partially cured 10 meters downstream from the solution application using a nitrogen-inerted 385 nm UV-LED system powered at 0.25 amps at 40 volts. The coated film was then laminated with one of the etch block coated with adhesion promoted films into a nip. The nip consisted of a 90-durometer rubber roll and steel roll set at 54 °C. The nip was engaged by two Bimba air cylinders pressed by 0.28 MPa of pressure. The laminated film stack was then exposed to a Fusion D bulb and the films were separated. The film separation yielded a nanostructured post array on the top of the etch-block coated and adhesion promoter coated film.

### Method of Fluorine Etching through the Nanostructured Mask and Etch Block Layer

After the nanostructured post array was replicated onto etch block coated film, it was desired to use a fluorine containing etch to ablate the thin 'land' layer between the posts, and to ablate through the adhesion promoting layer and oxygen-resistant etch block layer. The fluorine reactive ion etching was done in the same chamber described in the Method for a Release Treatment section. After placing the coated film on the powered electrode, the reactor chamber was pumped down to a base pressure of less than 1.3 Pa. A mixture of PF-5060 and O₂ were flowed into the chamber at 100 sccm and 25 sccm respectively. 13.56 MHz RF power was subsequently coupled into the reactor with an applied power of 7500 W. The film was then carried through the reaction zone at 0.61 meters per minute resulting in approximately 2.5 minutes of fluorine etching. After completing the fluorine etching step through the nanostructured land layer and etch block layer, the RF power was turned off and the gases were evacuated from the reactor.

### Method of Oxygen Etching the Nanostructure to Desired Depths

Following the fluorine containing etch, the oxygen-resistant etch-block layer was ablated in a patterned mask like that of the nanohole pattern. An oxygen etch would now be used to translate the nanohole pattern to a desired depth. In the case of a single etch block layer being used, the holes were translated to a depth dependent on the oxygen etching conditions. In a dual etch block configuration, the etch depth is self-limiting to the depth of the coated layer between the etch block layers.

The oxygen etching step took place in the same reactor without returning the chamber to atmospheric pressure. O₂ gas was flowed into the chamber at a flow rate of 300 sccm. 13.56 MHz RF power was subsequently coupled into the reactor with an applied power of 7500W. The rate at which the film was carried through the reactor can be found in Table 2, which notes the approximate depth of the etch, or pattern translation. In Examples 1-3, the depth was dependent on the time spent under the etching conditions, whereas Example 4 the final depth was set by the distance of the polymer layer or distance between etch stop layers.

**Table 2: Oxygen Etching Conditions**

| **Example Number** | **Etch Block Layer Configuration** | **Line Speed (meters per minute)** | **Approximate Etch Depth (nanometers)** |
|---|---|---|---|
| 1 | Single Layer | 1.22 | 500 |
| 2 | Single Layer | 0.61 | 800 |
| 3 | Single Layer | 0.30 | 1800 |
| 4 | Dual Layer | 0.41 | 800 |

### Method of Depositing Metal on the Nanohole Array

The etched nanohole array structures were then deposited with a metal layer to arrive at the final construction. The nanohole structures were vapor coated with Ag/Au using a roll-to-roll dc sputtering system with the target parallel to the substrate film during deposition. The sputtering target was 85%Ag/15%Au with dimensions 9.8 cm x 53.3 cm x 0.64 cm. The Ag/Au was deposited at an Argon pressure of 0.4 Pa and a power of 3.8 kW. Following the sputtering treatment, the pressure was returned to ambient pressure and the metallized nanohole array was removed from the machine.

### Experimental Example 1 - Creating a 500nm deep metalized nanohole array with a single etch stop layer

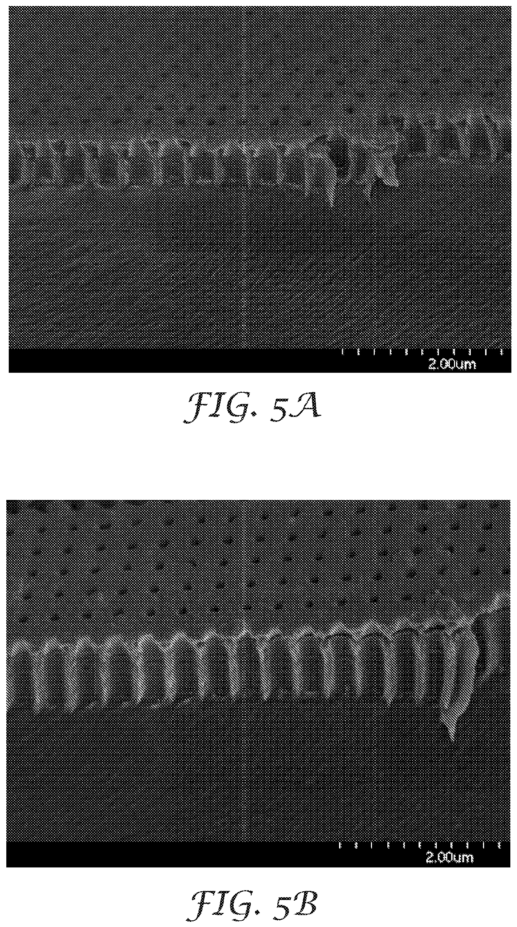

Step 1: A nanofeatured template was prepared using Resin A via Method of Making a Tooling Film via UV Replication;
Step 2: The nanofeatured template was release treated via Method for Release Treatment
Step 3: A single etch block layer containing SiCxOy was coated onto ST505 PET film via Method of Preparing a Single Etch Block Layer;
Step 4: An adhesion promoting layer was coated on the top of the ST505 film with single etch stop layer via Method of Liquid Coating the Adhesion Promoter;
Step 5: The adhesion promoter coated film from Step 4 was slot die coated with Resin B and replicated against the release treated tooling film to create a patterned nanoreplication mask via Method of Low-Land Transfer of Nanostructure onto Etch Block Film;
Step 6: A fluorine containing reactive ion etching process was carried out to etch through the recessed areas of the nanoreplication mask and through the thin oxygen etch stop layer via Method of Fluorine Etching through the Nanostructured Mask and Etch Block Layer;
Step 7: The nanohole array structure was translated into the ST505 film approximately 500nm via an oxygen etching step, following the conditions for Example 1 via Method of Oxygen Etching the Nanostructure to Desired Depths; and
Step 8: The 500nm deep nanohole array created in Step 7 was sputtered with a 150nm thick layer of 85%Au/15%Ag via Method of Depositing Metal on the Nanohole Array. This completed the fabrication of a 500nm deep nanohole array with 150nm 85%Au/15%Ag metal on top, a micrograph of this metallized nanohole array at 500nm is found in FIG. 5A.

### Experimental Example 2 - Creating an 800nm deep metalized nanohole array with a single etch stop layer

Step 1: A nanofeatured template was prepared using Resin A via Method of Making a Tooling Film via UV Replication;
Step 2: The nanofeatured template was release treated via Method for Release Treatment;
Step 3: A single etch block layer containing SiCxOy was coated onto ST505 PET film via Method of Preparing a Single Etch Block Layer;
Step 4: An adhesion promoting layer was coated on the top of the ST505 film with single etch stop layer via Method of Liquid Coating the Adhesion Promoter;
Step 5: The adhesion promoter coated film from Step 4 was slot die coated with Resin B and replicated against the release treated tooling film to create a patterned nanoreplication mask via Method of Low-Land Transfer of Nanostructure onto Etch Block Film;
Step 6: A fluorine containing reactive ion etching process was carried out to etch through the recessed areas of the nanoreplication mask and through the thin oxygen etch stop layer via Method of Fluorine Etching through the Nanostructured Mask and Etch Block Layer;
Step 7: The nanohole array structure was translated into the ST505 film approximately 800nm via an oxygen etching step, following the conditions for Example 2 via Method of Oxygen Etching the Nanostructure to Desired Depths, a micrograph cross section of the etched film to 800nm is found in FIG. 5B; and
Step 8: The 800nm deep nanohole array created in Step 7 was sputtered with a 150nm thick layer of 85%Au/15%Ag via Method of Depositing Metal on the Nanohole Array. This completed the fabrication of an 800nm deep nanohole array with 150nm 85%Au/15%Ag metal on top.

### Experimental Example 3 - Creating a 1800nm deep metalized nanohole array with a single etch stop layer

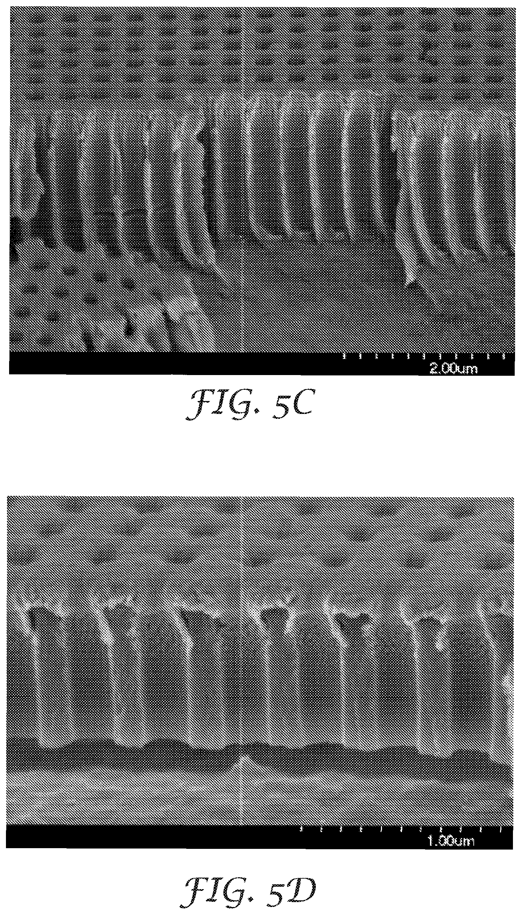

Step 1: A nanofeatured template was prepared using Resin A via Method of Making a Tooling Film via UV Replication;
Step 2: The nanofeatured template was release treated via Method for Release Treatment;
Step 3: A single etch block layer containing SiCxOy was coated onto ST505 PET film via Method of Preparing a Single Etch Block Layer;
Step 4: An adhesion promoting layer was coated on the top of the ST505 film with single etch stop layer via Method of Liquid Coating the Adhesion Promoter;
Step 5: The adhesion promoter coated film from Step 4 was slot die coated with Resin B and replicated against the release treated tooling film to create a patterned nanoreplication mask via Method of Low-Land Transfer of Nanostructure onto Etch Block Film;
Step 6: A fluorine containing reactive ion etching process was carried out to etch through the recessed areas of the nanoreplication mask and through the thin oxygen etch stop layer via Method of Fluorine Etching through the Nanostructured Mask and Etch Block Layer;
Step 7: The nanohole array structure was translated into the ST505 film approximately 1800 nm via an oxygen etching step, following the conditions for Example 3 via Method of Oxygen Etching the Nanostructure to Desired Depths, a micrograph cross section of the etched film to 1800nm is found in FIG. 5C; and
Step 8: The 1800nm deep nanohole array created in Step 7 was sputtered with a 150nm thick layer of 85%Au/15%Ag via Method of Depositing Metal on the Nanohole Array. This completed the fabrication of a 1800nm deep nanohole array with 150nm 85%Au/15%Ag metal on top.

### Experimental Example 4 - Creating an 800nm deep metalized nanohole array with a dual etch stop layer

Step 1: A nanofeatured template was prepared using Resin A via Method of Making a Tooling Film via UV Replication;
Step 2: The nanofeatured template was release treated via Method for Release Treatment;
Step 3: A dual etch stop layer containing SiAlOx , with a sandwiched layer of SR833 at 800nm thickness was deposited on the top of ST505 PET film to create a self-limiting thickness etch thickness for the nanohole array via Method of Preparing a Three-Layer Stack with Two Etch Block Layer;
Step 4: An adhesion promoting layer was coated on the top of the ST505 film with dual etch stop layers and SR833 coated layer via Method of Liquid Coating the Adhesion Promoter;
Step 5: The adhesion promoter coated film from Step 4 was slot die coated with Resin B and replicated against the release treated tooling film to create a patterned nanoreplication mask via Method of Low-Land Transfer of Nanostructure onto Etch Block Film;
Step 6: A fluorine containing reactive ion etching process was carried out to etch through the recessed areas of the nanoreplication mask and through the first thin oxygen etch stop layer via Method of Fluorine Etching through the Nanostructured Mask and Etch Block Layer;
Step 7: The nanohole array structure was translated into the 800nm thick coated SR833 layer via an oxygen etching step, following the conditions for Example 4 via Method of Oxygen Etching the Nanostructure to Desired Depths. Once the SR833 was etched through to the lower etch stop layer, further oxygen etching would not continue to ablate material in the Z-direction. This allowed the thickness of the nanohole array to be precisely tuned to the coating thickness of the SR833 layer; and
Step 8: The 800nm deep nanohole array created in Step 7 was sputtered with a 150nm thick layer of 85%Au/15%Ag via Method of Depositing Metal on the Nanohole Array. This completed the fabrication of an 800nm deep nanohole array with 150nm 85%Au/15%Ag metal on top. A micrograph cross section of the metal coated nanohole array is found in FIG. 5D.

Reference throughout this specification to "one embodiment," "certain embodiments," "one or more embodiments" or "an embodiment," whether or not including the term "exemplary" preceding the term "embodiment," means that a particular feature, structure, material, or characteristic described in connection with the embodiment is included in at least one embodiment of the certain exemplary embodiments of the present disclosure. Thus, the appearances of the phrases such as "in one or more embodiments," "in certain embodiments," "in one embodiment" or "in an embodiment" in various places throughout this specification are not necessarily referring to the same embodiment of the certain exemplary embodiments of the present disclosure. Furthermore, the particular features, structures, materials, or characteristics may be combined in any suitable manner in one or more embodiments.

While the specification has described in detail certain exemplary embodiments, it will be appreciated that those skilled in the art, upon attaining an understanding of the foregoing, may readily conceive of alterations to, variations of, and equivalents to these embodiments. Accordingly, it should be understood that this disclosure is not to be unduly limited to the illustrative embodiments set forth hereinabove. In particular, as used herein, the recitation of numerical ranges by endpoints is intended to include all numbers subsumed within that range (e.g., 1 to 5 includes 1, 1.5, 2, 2.75, 3, 3.80, 4, and 5). In addition, all numbers used herein are assumed to be modified by the term "about."

## Claims

1. A method comprising:
providing an array of nanowells on a first major surface of a polymeric layer, the array of nanowells including openings being interspersed between land areas thereof, the nanowells each having a base and a sidewall connecting the base and the land areas thereof; and
depositing a metallic layer at least on the land areas to form a mesh pattern of metal having an array of nanoholes aligned with the openings of the respective nanowells,
wherein the nanowells each have an aspect ratio of depth to opening size greater than 2:1 to prevent a substantial deposition of the metal into the nanowells on the bases thereof,
wherein the metallic layer has a first thickness T1 on the land areas, and a second thickness T2 on the base of the nanowells, the ratio of T2 over T1 is no greater than 50%, and
**characterized in that** providing the array of nanowells comprises:
providing a pattern layer on the first major surface of the polymeric layer, the pattern layer having a first surface adjacent to the etchable polymeric layer, and a second surface opposite to the first surface, the second surface including nanostructures **characterized by** feature dimensions of width, length, and height; and
etching from the second surface of the pattern layer into the first major surface of the etchable polymeric layer to form the array of nanowells;
and **characterized in that** depositing the metallic layer comprises sputter deposition with a sputter target and the polymeric layer positioned such that the sputter deposition is within ± 5 degrees from a direction normal to the first major surface of the polymeric layer.

2. The method of claim 1, wherein the nanowells each have the aspect ratio in a range from 3:1 to 10:1.

3. The method of claim 1 or claim 2, further comprising providing a hard mask layer on the first major surface of the polymeric layer, the hard mask layer being sandwiched between the pattern layer and the polymeric layer, wherein etching from the second surface of the pattern layer comprises etching the hard mask layer to form a pattern onto the hard mask layer using the pattern layer as a mask layer.

4. The method of claim 3, wherein etching from the second surface of the pattern layer further comprises etching into the polymeric layer using the pattern of the hard mask layer as a mask.

5. The method of claim 3 or claim 4, further comprising providing an etch stop layer adjacent to a second major surface of the polymeric layer on the side opposite the hard mask layer on the first major surface of the polymeric layer.

6. The method of claim 5, further comprising providing a support film, the etch stop layer being sandwiched between the polymeric layer and the support film, wherein the etching of the polymeric layer is automatically stopped at the etch stop layer such that the nanowells each have the bases thereof reaching the etch stop layer.

7. The method of any one of claims 1-6, wherein the pattern layer is a nano-replicated resin layer comprising a curable composition, optionally, a UV-curable acrylate.

8. The method of any one of claims 1-7, wherein the polymeric layer comprises at least one of a curable composition, monomer, or solution coatable polymer.

9. The method of any one of claims 1-8, wherein the array of nanowells has an average pitch in a range from 100 nm to 2500 nm, from 100 nm to 1000 nm, from 250 nm to 1000 nm, or optionally from 300 nm to 900 nm, an average opening size in a range from 10 to 90 percent of the pitch, and an average depth in a range from 50 nm to 5000 nm.

10. An article comprising:
an etchable polymeric layer having a first major surface and a second major surface opposite the first major surface;
an array of nanowells formed into the first major surface of the etchable polymeric layer, the array of nanowells including openings being interspersed between land areas thereof, the nanowells each having a base and a sidewall connecting the base and the land areas thereof, the nanowells each having a ratio of depth to opening size from 2:1 to 10:1; and
a metallic layer disposed at least on the land areas, the metallic layer forming a mesh pattern having an array of nanoholes aligned with the openings of the respective nanowells;
**characterized in that** the metallic layer extends from the land areas into the nanowells along the sidewalls with a depth no less than 3% and no greater than 95% of the nanowell depth;
and **in that** the metallic layer has a first thickness T1 on the land areas, and a second thickness T2 on the base of the nanowells, the ratio of T2 over T1 is no greater than 5%.

11. The article of claim 10, wherein the nanowells each have the aspect ratio of depth to opening size in a range from 3:1 to 10:1.

12. The article of claim 10 or claim 11, wherein the metallic layer extends from the land areas into the nanowells along the sidewalls with a depth no less than 3% and no greater than 20% of the nanowell depth.

13. The article of any one of claims 10-12, further comprising a support film disposed on the second major surface of the etchable polymeric layer.

14. The article of any one of claims 10-13, wherein the etchable polymeric layer comprises at least one of a curable composition, monomer, or solution coatable polymer.

15. The article of any one of claims 10-14, wherein the metallic layer comprises at least one of gold, silver, aluminum, copper, platinum, ruthenium, nickel, palladium, rhodium, iridium, chromium, iron, lead, tin, zinc, a combination or alloy thereof.

16. The article of any one of claims 10-15, wherein the mesh pattern of the metallic layer is a repeating pattern including at least one of a square lattice, a rectangular lattice, a hexagonal lattice, a rhombic lattice, or a parallelogrammic lattice.

17. The article of any one of claims 10-16, further comprising a hard mask layer on the land areas on the first major surface of the etchable polymeric layer, the hard mask layer being sandwiched between the metal and the etchable polymeric layer.

18. The article of claim 17, further comprising an etch stop layer adjacent to a second major surface of the etchable polymeric layer on the side opposite the hard mask layer on the first major surface of the etchable polymeric layer.

19. The article of any one of claims 10-18, which is a flexible sensor device.

20. The article of any one of claims 10-19, which has a thickness no greater than about 500 micrometers.

## Patentansprüche

1. Ein Verfahren, umfassend:
Bereitstellen einer Anordnung von Nanovertiefungen auf einer ersten Hauptoberfläche einer Polymerschicht, wobei die Anordnung von Nanovertiefungen Öffnungen enthält, die zwischen Landbereichen davon eingestreut sind, wobei die Nanovertiefungen jeweils eine Basis und eine Seitenwand aufweisen, die die Basis und die Landbereiche davon verbindet; und
Abscheiden einer Metallschicht mindestens auf den Landbereichen, um ein Netzmuster aus Metall zu bilden, das eine Anordnung von Nanolöchern aufweist, die mit den Öffnungen der jeweiligen Nanovertiefungen ausgerichtet sind,
wobei die Nanovertiefungen jeweils ein Seitenverhältnis von Tiefe zu Öffnungsgröße von größer als 2 : 1 aufweisen, um eine wesentliche Abscheidung des Metalls in den Nanovertiefungen an den Basen davon zu verhindern,
wobei die metallische Schicht auf den Landbereichen eine erste Dicke T1 und auf der Basis der Nanovertiefungen eine zweite Dicke T2 aufweist, wobei das Verhältnis von T2 gegenüber T1 nicht größer als 50 % ist und
**dadurch gekennzeichnet, dass** das Bereitstellen der Anordnung von Nanovertiefungen umfasst:
Bereitstellen einer Musterschicht auf der ersten Hauptoberfläche der Polymerschicht, wobei die Musterschicht eine erste Oberfläche angrenzend an die ätzbare Polymerschicht und eine zweite Oberfläche gegenüberliegend der ersten Oberfläche aufweist, wobei die zweite Oberfläche Nanostrukturen enthält, die durch Merkmalsabmessungen von Breite, Länge und Höhe gekennzeichnet sind; und
Ätzen von der zweiten Oberfläche der Musterschicht in die erste Hauptoberfläche der ätzbaren Polymerschicht, um die Anordnung von Nanovertiefungen zu bilden; und **dadurch gekennzeichnet, dass**
das Abscheiden der Metallschicht eine Sputterabscheidung mit einem Sputterziel umfasst und die Polymerschicht derart positioniert ist, dass die Sputterabscheidung innerhalb von ± 5 Grad von einer Richtung senkrecht zu der ersten Hauptoberfläche der Polymerschicht erfolgt.

2. Das Verfahren nach Anspruch 1, wobei die Nanovertiefungen jeweils das Seitenverhältnis in einem Bereich von 3 : 1 bis 10 : 1 aufweisen.

3. Das Verfahren nach Anspruch 1 oder 2, ferner umfassend das Bereitstellen einer Hartmaskenschicht auf der ersten Hauptoberfläche der Polymerschicht, wobei die Hartmaskenschicht zwischen der Musterschicht und der Polymerschicht eingeschoben ist, wobei das Ätzen von der zweiten Oberfläche der Musterschicht das Ätzen der Hartmaskenschicht umfasst, um ein Muster auf der Hartmaskenschicht unter Verwendung der Musterschicht als eine Maskenschicht zu bilden.

4. Das Verfahren nach Anspruch 3, wobei das Ätzen von der zweiten Oberfläche der Musterschicht ferner das Ätzen in die Polymerschicht unter Verwendung des Musters der Hartmaskenschicht als eine Maske umfasst.

5. Das Verfahren nach Anspruch 3 oder Anspruch 4, ferner umfassend das Bereitstellen einer Ätzstoppschicht angrenzend an eine zweite Hauptoberfläche der Polymerschicht auf der Seite gegenüberliegend der Hartmaskenschicht auf der ersten Hauptoberfläche der Polymerschicht.

6. Das Verfahren nach Anspruch 5, ferner umfassend das Bereitstellen einer Trägerfolie, wobei die Ätzstoppschicht zwischen der Polymerschicht und der Trägerfolie eingeschoben ist, wobei das Ätzen der Polymerschicht an der Ätzstoppschicht derart automatisch gestoppt wird, dass die Nanovertiefungen jeweils die die Ätzstoppschicht erreichenden Basen davon aufweisen.

7. Das Verfahren nach einem der Ansprüche 1 bis 6, wobei die Musterschicht eine nanoreplizierte Harzschicht ist, umfassend eine härtbare Zusammensetzung, gegebenenfalls ein UV-härtbares Acrylat.

8. Das Verfahren nach einem der Ansprüche 1 bis 7, wobei die Polymerschicht mindestens eines von einer härtbaren Zusammensetzung, einem Monomer oder einem lösungsbeschichtbaren Polymer umfasst.

9. Das Verfahren nach einem der Ansprüche 1 bis 8, wobei die Anordnung von Nanovertiefungen einen durchschnittlichen Abstand in einem Bereich von 100 nm bis 2500 nm, von 100 nm bis 1000 nm, von 250 nm bis 1000 nm oder gegebenenfalls von 300 nm bis 900 nm, eine durchschnittliche Öffnungsgröße in einem Bereich von 10 bis 90 Prozent des Abstands und eine durchschnittliche Tiefe in einem Bereich von 50 nm bis 5000 nm aufweist.

10. Ein Gegenstand, umfassend:
eine ätzbare Polymerschicht, die eine erste Hauptoberfläche und eine zweite Hauptoberfläche gegenüberliegend der ersten Hauptoberfläche aufweist;
eine Anordnung von Nanovertiefungen, die in der ersten Hauptoberfläche der ätzbaren Polymerschicht gebildet ist, wobei die Anordnung von Nanovertiefungen Öffnungen enthält, die zwischen den Landbereichen davon eingestreut sind, wobei die Nanovertiefungen jeweils eine Basis und eine Seitenwand haben, die die Basis und die Landbereiche davon verbindet, wobei die Nanovertiefungen jeweils ein Verhältnis von Tiefe zu Öffnungsgröße von 2 : 1 bis 10 : 1 aufweisen; und
eine metallische Schicht, die mindestens auf den Landbereichen eingerichtet ist, wobei die metallische Schicht ein Netzmuster bildet, das eine Anordnung von Nanolöchern aufweist, die mit den Öffnungen der jeweiligen Nanovertiefungen ausgerichtet sind; **dadurch gekennzeichnet, dass**
sich die Metallschicht von den Landbereichen in die Nanovertiefungen entlang der Seitenwände mit einer Tiefe von nicht weniger als 3 % und nicht größer als 95 % der Nanovertiefungstiefe erstreckt; und dass
die Metallschicht auf den Landbereichen eine erste Dicke T1 und auf der Basis der Nanovertiefungen eine zweite Dicke T2 aufweist, wobei das Verhältnis von T2 gegenüber T1 nicht größer als 5 % ist.

11. Der Gegenstand nach Anspruch 10, wobei die Nanovertiefungen jeweils ein Seitenverhältnis von Tiefe zu Öffnungsgröße in einem Bereich von 3 : 1 bis 10 : 1 aufweisen.

12. Der Gegenstand nach Anspruch 10 oder 11, wobei sich die Metallschicht von den Landbereichen in die Nanovertiefungen entlang der Seitenwände mit einer Tiefe von nicht weniger als 3 % und nicht größer als 20 % der Nanovertiefungstiefe erstreckt.

13. Der Gegenstand nach einem der Ansprüche 10 bis 12, ferner umfassend eine Trägerfolie, die auf der zweiten Hauptoberfläche der ätzbaren Polymerschicht eingerichtet ist.

14. Der Gegenstand nach einem der Ansprüche 10 bis 13, wobei die ätzbare Polymerschicht mindestens eines von einer härtbaren Zusammensetzung, einem Monomer oder einem lösungsbeschichtbaren Polymer umfasst.

15. Der Artikel nach einem der Ansprüche 10 bis 14, wobei die metallische Schicht mindestens eines von Gold, Silber, Aluminium, Kupfer, Platin, Ruthenium, Nickel, Palladium, Rhodium, Iridium, Chrom, Eisen, Blei, Zinn, Zink, eine Kombination oder eine Legierung davon umfasst.

16. Der Gegenstand nach einem der Ansprüche 10 bis 15, wobei das Netzmuster der metallischen Schicht ein sich wiederholendes Muster ist, einschließend mindestens eines von einem quadratischen Gitter, einem rechteckigen Gitter, einem hexagonalen Gitter, einem rhombischen Gitter oder einem parallelogrammförmigen Gitter.

17. Der Gegenstand nach einem der Ansprüche 10 bis 16, ferner umfassend eine Hartmaskenschicht auf den Landbereichen auf der ersten Hauptoberfläche der ätzbaren Polymerschicht, wobei die Hartmaskenschicht zwischen dem Metall und der ätzbaren Polymerschicht eingeschoben ist.

18. Der Gegenstand nach Anspruch 17, ferner umfassend eine Ätzstoppschicht angrenzend an eine zweite Hauptoberfläche der ätzbaren Polymerschicht auf der Seite gegenüberliegend der Hartmaskenschicht auf der ersten Hauptoberfläche der ätzbaren Polymerschicht.

19. Der Gegenstand nach einem der Ansprüche 10 bis 18, der eine flexible Sensorvorrichtung ist.

20. Der Gegenstand nach einem der Ansprüche 10 bis 19, der eine Dicke von nicht größer als etwa 500 Mikrometern aufweist.

## Revendications

1. Procédé comprenant :
la fourniture d'une matrice de nanopuits sur une première surface principale d'une couche polymère, la matrice de nanopuits comportant des ouvertures étant entrecoupées entre des zones plates de celle-ci, les nanopuits ayant chacun une base et une paroi latérale reliant la base et les zones plates de ceux-ci ; et
le dépôt d'une couche métallique au moins sur les zones plates pour former un motif de maillage de métal ayant une matrice de nanotrous alignés avec les ouvertures des nanopuits respectifs,
dans lequel les nanopuits ont chacun un rapport d'aspect de la profondeur à la taille d'ouverture supérieur à 2:1 pour empêcher un dépôt sensible du métal dans les nanopuits sur les bases de ceux-ci,
dans lequel la couche métallique a une première épaisseur T1 sur les zones plates, et une seconde épaisseur T2 sur la base des nanopuits, le rapport de T2 à T1 n'étant pas supérieur à 50 %, et
**caractérisé en ce que** la fourniture de la matrice de nanopuits comprend :
la fourniture d'une couche de motif sur la première surface principale de la couche polymère, la couche de motif ayant une première surface adjacente à la couche polymère gravable, et une seconde surface opposée à la première surface, la seconde surface comportant des nanostructures **caractérisées par** des dimensions caractéristiques de largeur, longueur et hauteur ; et
la gravure à partir de la seconde surface de la couche de motif dans la première surface principale de la couche polymère gravable pour former la matrice de nanopuits ; et **caractérisé en ce que**
le dépôt de la couche métallique comprend un dépôt par pulvérisation avec une cible de pulvérisation et la couche polymère positionnée de telle sorte que le dépôt par pulvérisation est à ± 5 degrés par rapport à une direction normale à la première surface principale de la couche polymère.

2. Procédé selon la revendication 1, dans lequel les nanopuits ont chacun le rapport d'aspect dans une plage allant de 3:1 à 10:1.

3. Procédé selon la revendication 1 ou la revendication 2, comprenant en outre la fourniture d'une couche de masque dure sur la première surface principale de la couche polymère, la couche de masque dure étant placée en sandwich entre la couche de motif et la couche polymère, dans lequel une gravure à partir de la seconde surface de la couche de motif comprend une gravure de la couche de masque dure pour former un motif sur la couche de masque dure à l'aide de la couche de motif en guise de couche de masque.

4. Procédé selon la revendication 3, dans lequel la gravure à partir de la seconde surface de la couche de motif comprend en outre la gravure dans la couche polymère à l'aide du motif de la couche de masque dure en guise de masque.

5. Procédé selon la revendication 3 ou la revendication 4, comprenant en outre la fourniture d'une couche d'arrêt de gravure adjacente à une seconde surface principale de la couche polymère sur le côté opposé à la couche de masque dure sur la première surface principale de la couche polymère.

6. Procédé selon la revendication 5, comprenant en outre la fourniture d'un film de support, la couche d'arrêt de gravure étant placée en sandwich entre la couche polymère et le film de support, dans lequel la gravure de la couche polymère est automatiquement arrêtée au niveau de la couche d'arrêt de gravure de telle sorte que les nanopuits ont chacun les bases de ceux-ci atteignant la couche d'arrêt de gravure.

7. Procédé selon l'une quelconque des revendications 1 à 6, dans lequel la couche de motif est une couche de résine nano-répliquée comprenant une composition durcissable, facultativement, un acrylate durcissable aux UV.

8. Procédé selon l'une quelconque des revendications 1 à 7, dans lequel la couche polymère comprend au moins l'un parmi une composition durcissable, un monomère, ou un polymère pouvant être revêtu en solution.

9. Procédé selon l'une quelconque des revendications 1 à 8, dans lequel le matrice de nanopuits a un pas moyen dans une plage allant de 100 nm à 2500 nm, de 100 nm à 1000 nm, de 250 nm à 1000 nm, ou facultativement de 300 nm à 900 nm, une taille moyenne d'ouverture dans une plage allant de 10 à 90 pour cent du pas, et une profondeur moyenne dans une plage allant de 50 nm à 5000 nm.

10. Article comprenant :
une couche polymère gravable ayant une première surface principale et une seconde surface principale opposée à la première surface principale ;
une matrice de nanopuits formés dans la première surface principale de la couche polymère gravable, la matrice de nanopuits comportant des ouvertures étant entrecoupées entre des zones plates de celle-ci, les nanopuits ayant chacun une base et une paroi latérale reliant la base et les zones plates de ceux-ci, les nanopuits ayant chacun un rapport de la profondeur à la taille d'ouverture allant de 2:1 à 10:1 ; et
une couche métallique disposée au moins sur les zones plates, la couche métallique formant un motif de maillage ayant une matrice de nanotrous alignés avec les ouvertures des nanopuits respectifs ; **caractérisé en ce que**
la couche métallique s'étend à partir des zones plates dans les nanopuits le long des parois latérales avec une profondeur d'au moins 3 % et n'excédant pas 95 % de la profondeur de nanopuits ; **et en ce que**
la couche métallique a une première épaisseur T1 sur les zones plates, et une seconde épaisseur T2 sur la base des nanopuits, le rapport de T2 à T1 n'étant pas supérieur à 5 %.

11. Article selon la revendication 10, dans lequel les nanopuits ont chacun le rapport d'aspect de la profondeur à la taille d'ouverture dans une plage allant de 3:1 à 10:1.

12. Article selon la revendication 10 ou la revendication 11, dans lequel la couche métallique s'étend à partir des zones plates dans les nanopuits le long des parois latérales avec une profondeur d'au moins 3 % et n'excédant pas 20 % de la profondeur de nanopuits.

13. Article selon l'une quelconque des revendications 10 à 12, comprenant en outre un film de support disposé sur la seconde surface principale de la couche polymère gravable.

14. Article selon l'une quelconque des revendications 10 à 13, dans lequel la couche polymère gravable comprend au moins l'un parmi une composition durcissable, un monomère, ou un polymère pouvant être revêtu en solution.

15. Article selon l'une quelconque des revendications 10 à 14, dans lequel la couche métallique comprend au moins l'un parmi or, argent, aluminium, cuivre, platine, ruthénium, nickel, palladium, rhodium, iridium, chrome, fer, plomb, étain, zinc, une combinaison ou un alliage de ceux-ci.

16. Article selon l'une quelconque des revendications 10 à 15, dans lequel le motif de maillage de la couche métallique est un motif répétitif comportant au moins l'un parmi un réseau carré, un réseau rectangulaire, un réseau hexagonal, un réseau rhombique ou un réseau en parallélogramme.

17. Article selon l'une quelconque des revendications 10 à 16, comprenant en outre une couche de masque dure sur les zones plates sur la première surface principale de la couche polymère gravable, la couche de masque dure étant placée en sandwich entre le métal et la couche polymère gravable.

18. Article selon la revendication 17, comprenant en outre une couche d'arrêt de gravure adjacente à une seconde surface principale de la couche polymère gravable sur le côté opposé à la couche de masque dure sur la première surface principale de la couche polymère gravable.

19. Article selon l'une quelconque des revendications 10 à 18, qui est un dispositif capteur flexible.

20. Article selon l'une quelconque des revendications 10 à 19, qui a une épaisseur n'excédant pas environ 500 micromètres.
